Europäisches Patentamt

European Patent Office

Office européen des brevets

(11) Publication number: 0 276 571
A2

# (12) EUROPEAN PATENT APPLICATION

(21) Application number: 87311416.9

(22) Date of filing: 23.12.87

(51) Int. Cl.⁴: **H01L 21/76 , H01L 21/74**

The title of the invention has been amended (Guidelines for Examination in the EPO, A-III, 7.3).

(30) Priority: 28.01.87 JP 17529/87

(43) Date of publication of application:
03.08.88 Bulletin 88/31

(84) Designated Contracting States:
DE FR GB

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Maeda, Takeo c/o Patent Division**
**Toshiba Corp.**
**Principal Office 1-1 Shibaura 1-chome**
**Minato-ku Tokyo 105(JP)**

(74) Representative: **Sturt, Clifford Mark et al**
**MARKS & CLERK 57-60 Lincoln's Inn Fields**
**London WC2A 3LS(GB)**

(54) **Method of manufacturing a semiconductive device comprising a buried region.**

(57) This invention provides a method of manufacturing a semiconductor device comprising, forming an oxidation-resistant film (23) on a semiconductor substrate (21), forming a mask (24) for etching by providing resist on the oxidation-resistant film (23), selectively removing the oxidation-resistant film (23) by isotropic etching using the said mask (24), forming on the substrate surface a semiconductor region (25) of a first conductivity type, by introducing impurity of the first conductivity type into the semiconductor substrate (21) using the said mask (24), forming an oxide film (26) on the semiconductor substrate (21) by oxidizing the semiconductor substrate using the oxidation-resistant film (23) as a mask, forming a semiconductor region (27) of a second conductivity type separated from the semiconductor region (25) of the first conductivity type by introducing impurity of the second conductivity type into the semiconductor substrate (21) using the oxide film (26) as a mask, and growing an epitaxial layer (28) on the semiconductor substrate (21).

FIG.2.

## Method of manufacturing a semiconductor device

This invention relates to a method of manufacturing a semiconductor device. In particular, this invention relates to a method of manufacturing a bipolar transistor with the object of increased miniaturization.

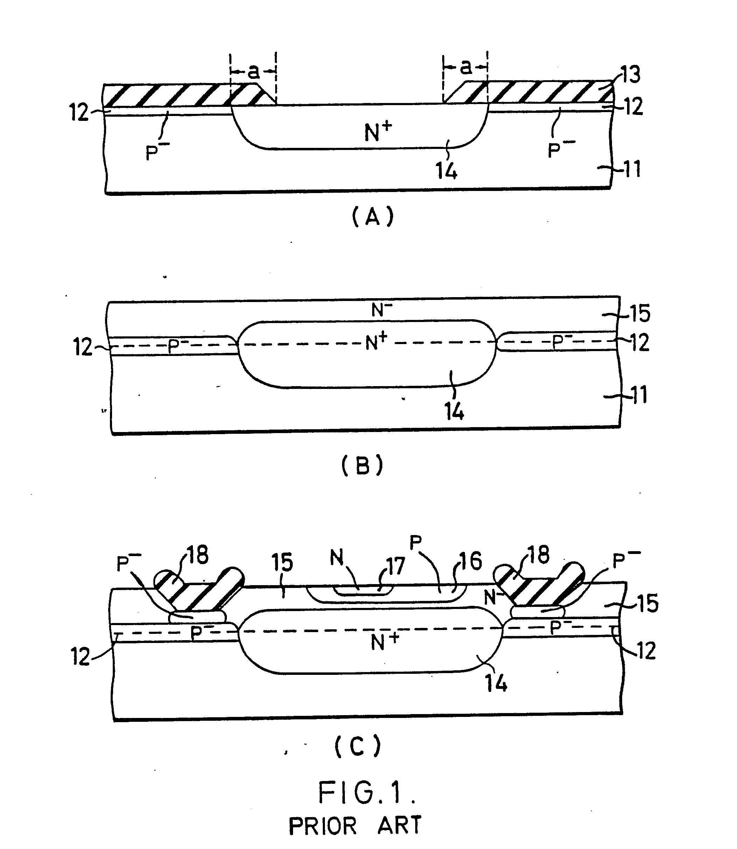

When bipolar transistor elements of very small size are formed using conventional techniques, first of all, as shown in Fig. 1(A), a $P^-$ diffusion layer 12 is formed on the surface of a P type silicon substrate 11. Next, a silicon oxide film 13 of about 0.8 micron thickness is formed on substrate 11, then this is selectively etched away. Using silicon oxide film 13 that is left behind as a mask, an $N^+$ diffusion layer 14 is formed by injecting antimony (Sb) into substrate 11 by vapour diffusion.

However, in selectively etching silicon oxide film 13, the thickness of oxide film 13 may be reduced on both sides of the etched region by over-etching. These thin parts of the film allow antimony to pass through, with the result that the region of antimony injection is wider than desired. And since the solid solubility of antimony in silicon is low, to make the collector resistance sufficiently low, a deep $N^+$ diffusion layer 14 must be formed. Thus the extent of this widening in the transverse direction becomes very appreciable.

For these reasons, conversion differences of about 2 micron as shown by "a" are respectively introduced on both sides of $N^+$ diffusion layer 14 so that the width of the $N^+$ diffusion layer 14 ends up becoming about 4 microns larger than the desired value. This implies that a collector region cannot be formed narrower than 4 microns.

Next, as shown in Fig. 1(B), an eptiaxial layer 15 is deposited over the whole surface at a temperature of 1100 °C, N type impurities being introduced into it. Whilst this is being done, due to auto-doping, the impurities of $P^-$ diffusion layer 12 and $N^+$ diffusion layer 14 respectively get mixed into $N^-$ epitaxial layer 15. As a result, $P^-$ diffusion layer 12 and $N^+$ diffusion layer 14 respectively extend into epitaxial layer 15, reducing the thickness of epitaxial layer 15.

For this reason, when P type base region 16 and N type emitter region 17 are respectively formed in $N^-$ layer 15 as shown in Fig. 1(C), the thickness of P type base region 16 is reduced, with the result that "punch-through" may occur between emitter region 17 and the collector region (epitaxial layer 15).

To overcome this problem and obtain a transistor of high reliability, the thickness of epitaxial layer 15 may be increased, but if the thickness of epitaxial layer 15 is increased, the thickness of the element separation region must also be increased to a corresponding degree. Consequently, either a ditch-like field insulating film 18 must be formed as shown in Fig. 1(C), or a P type region must be formed over the whole of the thickness of epitaxial layer 15.

Forming a ditch-like field insulating film 18 makes the manufacturing process complicated. And to form a P type region over the whole of the thickness of epitaxial layer 15, P type impurity must be diffused from above and below epitaxial layer 15 by injecting P type impurity before and after forming epitaxial layer 15. However, if the concentration of P type impurity is made sufficiently high to obtain sufficient mixing of the P type impurity from the layer below epitaxial layer 15, this tends to result in a deterioration of the breakdown withstand voltage of the PN junction between substrate 11 and collector region (epitaxial layer 15 and $N^+$ layer 14). The concentration of P type impurity injected from the layer above epitaxial layer 15 cannot be made very high, since it would affect the field inversion voltage.

An object of this invention is to provide a method of manufacturing a semiconductor device which makes it possible to reduce the element size, yet enable the element to be manufactured with high reliability while using a simple manufacturing process.

This invention provides a method of manufacturing a semiconductor device comprising, forming an oxidation-resistant film on a semiconductor substrate, forming a mask for etching by providing resist onto the oxidation-resistant film, selectively removing the oxidation-resistant film by isotropic etching using mask, forming a semiconductor region of a first conductivity type on the substrate surface, by introducing impurity of first conductivity type into the semiconductor substrate using the mask, forming an oxide film on the semiconductor substrate by oxidizing the semiconductor substrate using the oxidation-resistant film as a mask, forming a semiconductor region of second conductivity type separated from the semiconductor region of first conductivity type by introducing impurity of second conductivity type into the semiconductor substrate using the oxide film as a mask, and growing an epitaxial layer on the semiconductor substrate.

By using this method of manufacture, the semiconductor region of first conductivity type, which has a higher degree of doping than the substrate, and the semiconductor region of second conductivity type can be formed separated from each other in a self-aligned manner. Thus, the width of the semiconductor region of second conductivity type can be effectively reduced. Also an element isolating region can be formed which maintains sufficient breakdown voltage of the PN junction between the substrate and semiconductor region of second conductivity type. Furthermore, if arsenic is used as the impurity of the second conductivity type, the width of the second conductivity type semiconductor region can be further reduced. And by growing the epitaxial layer at a low temperature, below 950°C, auto-doping of second conductivity type impurity into this epitaxial layer can be suppressed, making formation of a thick epitaxial layer unnecessary. Also, since the first conductivity type semiconductor region is formed with a high degree of doping, even though the epitaxial layer is grown at low temperature, a sufficient amount of admixture of first conductivity type impurity into this epitaxial layer can be obtained. This therefore facilitates formation of an element isolating region.

An embodiment of this invention will now be described by way of example only and with reference to the accompanying drawings, in which :-

Figure 1 is a cross-section constructional diagram given in explanation of a conventional method of manufacturing a semiconductor device.

Figure 2 is a cross-section constructional diagram given in explanation of the method of manufacturing a semiconductor device according to an embodiment of this invention.

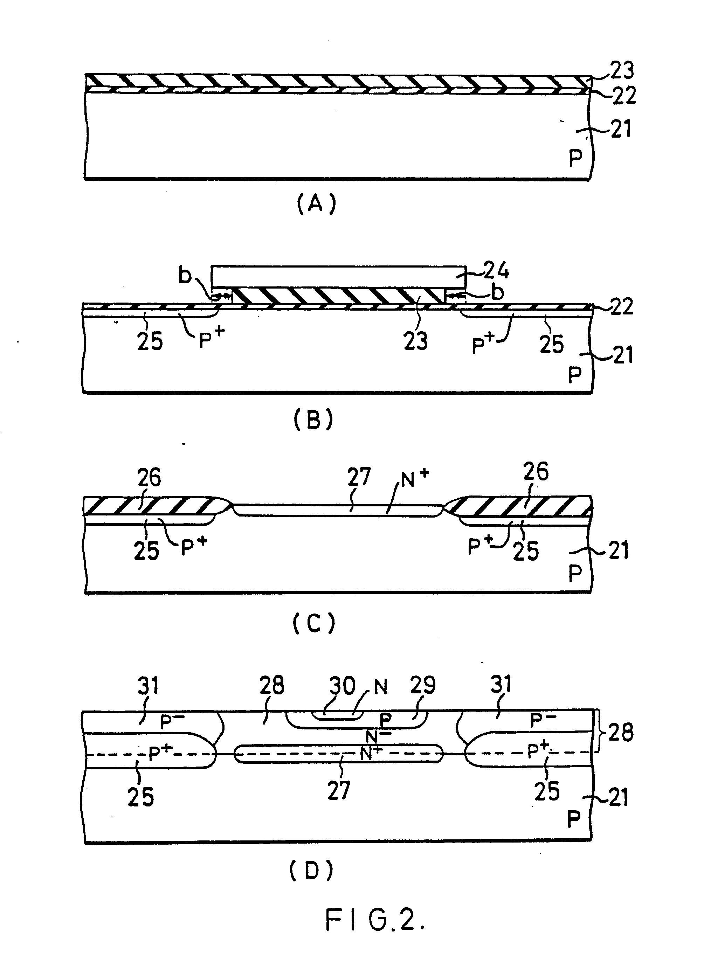

The embodiment of the invention described below with reference to Figure 2 relates to the formation of an NPN bipolar transistor.

First of all, as shown in Figure 2, a thermal oxide film 22 of thickness about 500 to 2000 Angstrom (500 to 2000x10$^{-10}$m) is formed on the principal surface of a P type (100) silicon substrate 21 of resistivity 0.5 to 20 ohm-cm by heat treatment at 900 to 1000 °C. Subsequently a silicon nitride film 23 is deposited on the thermal oxide film 22, by a CVD method, to a thickness of about 1000 to 5000 Angstrom (1 to 5 x 10$^{-7}$m).

Next, as shown in Figure 2 (B), using as a mask resist layer 24 which is selectively left behind, silicon film 23 is selectivety etched away by isotropic etching such as CDE etching. In this case, that part of the silicon nitride film 23 which is below resist layer 24 is also over-etched, with the result that conversion differences "b" of about 0.25 micron are respectively introduced on both sides thereof. Then, using resist layer 24 as a mask, boron ions are implanted in substrate 21 to form a P$^+$ impurity region 25.

Next, as shown in Figure 2(C), resist layer 24 is removed then, using as a mask the silicon nitride film 23 which is left behind, a thermal oxide film 26 of about 0.1 to 1.0 micron thickness is formed in a wet oxidizing atmosphere of 950 to 1000°C. Then, using this thermal oxide film 26 as a mask, N type impurity ions are implanted to form an N$^+$ impurity region 27. In this case, due to the conversion difference b which is introduced in selectively etching the silicon nitride film 23, N$^+$ impurity region 27 is formed separated from P$^+$ impurity region 25. Thus, by forming N$^+$ impurity region 27 in self-aligned manner in a condition separated from P$^+$ impurity region 25, N$^+$ impurity region 27 can be reduced in size, and the PN junction breakdown voltage between substrate 21 and N$^+$ impurity region 27 can be increased. The N type impurity used is arsenic, for example.

Arsenic has a higher solid solubility in silicon than does antimony, so even though N$^+$ impurity region 27 is made thin, the collector resistance can be lowered to a sufficient degree. Consequently, spreading in the transverse direction of N$^+$ impurity region 27 can be restrained.

Next, as shown in Figure 2(D), thermal oxide film 26 is removed in NH$_4$F solution, then an N-epitaxial layer 28 is deposited over the entire surface at low temperature i.e. below 950 °C (for example about 800 to 950°C).

In forming this epitaxial layer 28, respective impurities become mixed with epitaxial layer 28 by autodoping from P$^+$ impurity region 25 and N$^+$ impurity region 27. However, in this case, since epitaxial layer 28 is formed at a low temperature, below 950°C, the amount of N$^+$ impurity region 27 that permeates into this epitaxial layer 28 is less than in the conventional arrangement. And if, before forming this epitaxial layer 28, the impurity in N$^+$ impurity region 27 is diffused by carrying out heat treatment at 1000 to 1190°C, so that its surface concentration is lowered, the amount of permeation from N$^+$ impurity region 27 into N$^-$ epitaxial layer 28 can be further reduced. The film thickness of N$^-$ epitaxial layer 28, that constitutes the collector region, can therefore be fully assured, even without making epitaxial layer 28 thicker, as is done in the conventional arrangement.

Typically, a P type base region 29, N type emitter region 30, and P$^-$ impurity region 31 (for element isolation) are then formed. In this case, since P$^+$ impurity region 25 is formed with a high degree of doping, even though N$^-$ epitaxial layer 28 is formed at low temperature, the amount of P type impurities that become admixed with this layer 28 can be made sufficiently large, and (as described above) because the epitaxial layer 28 can be made thin, in forming P$^-$ impurity region 31, only a small amount of impurity is needed to achieve the required object. Thus, formation of the element isolation region is facilitated.

Furthermore, depending on the thickness of oxide film 26; in growing epitaxial layer 28 after this oxide film 26 is removed, the thickness of epitaxial layer 28 formed on the surface of P$^+$ impurity region 25 is thinner than that of epitaxial layer 28 formed on the surface of the $N^+$ impurity region 27. This results in the formation of a step. If this step is utilized as a reference for mask alignment in forming field isolation region, P type base region 29, N type emitter region 30, and P-impurity region 31, misalignment can be reduced.

In the above embodiment, $P^+$ impurity region 25 is formed using resist layer 24 as a mask and $N^+$ impurity region 27 is formed using thermal oxide film 26 as a mask. However, $N^+$ impurity region can be formed using the resist layer as a mask and $P^+$ impurity region can be formed using thermal oxide film 26 as a mask.

As described above, this invention provides a method of manufacturing a semiconductor device wherein improvement is achieved in respect of point (i), namely, that with the conventional method of manufacture the width of the buried layer cannot be reduced to lower the collector resistance, so that it is difficult to reduce the element size, and point (ii), namely that if the epitaxial layer is made sufficiently thick to avoid punch-through between emitter and collector, formation of an element isolating region is difficult. With this invention, element size can be reduced and a semiconductor device of high reliability can be manufactured with simple manufacturing steps.

Various modifications can be made to the described embodiment without departing from the scope of the invention.

## Claims

1. A method of manufacturing a semiconductor device characterised by comprising:

forming an oxidation-resistant film (23) on a semiconductor substrate (21);

forming a mask (24) for etching by providing resist on the oxidation-resistant film (23);

selectively removing the oxidation-resistant film (23) by isotropic etching using the said mask (24);

forming on the substrate surface a semiconductor region (25) of a first conductivity type, by introducing impurity of the first conductivity type into the semiconductor substrate (21) using the said mask (24);

forming an oxide film (26) on the semiconductor substrate (21) by oxidizing the semiconductor substrate using the oxidation-resistant film (23) as a mask;

forming a semiconductor region (27) of a second conductivity type separated from the semiconductor region (25) of the first conductivity type by introducing impurity of the second conductivity type into the semiconductor substrate (21) using the oxide film (26) as a mask; and

growing an epitaxial layer (28) on the semiconductor substrate (21).

2. A method of manufacturing a semiconductor device as claimed in claim 1, further characterised in that arsenic is used as the impurity of the second conductivity type.

3. A method of manufacturing a semiconductor device as claimed in claim 1 or 2, further characterised in that the epitaxial layer growth step is carried out at a temperature below 950°C.

4. A method of manufacturing a semiconductor device as claimed in claim 1, further characterised by heating the semiconductor substrate to reduce the surface doping concentration of the semiconductor region (27) of the second conductivity type before growing the epitaxial layer (28).

(A)

(B)

(C)

FIG.1.
PRIOR ART

(A)

(B)

(C)

(D)

FIG.2.